Europäisches Patentamt

European Patent Office

Office européen des brevets

(11) Veröffentlichungsnummer: **0 311 129**
**A1**

(12) **EUROPÄISCHE PATENTANMELDUNG**

(21) Anmeldenummer: 88116709.2

(22) Anmeldetag: 07.10.88

(51) Int. Cl.4: **H03K 17/95 , G01F 1/075**

(30) Priorität: 07.10.87 DE 3733944

(43) Veröffentlichungstag der Anmeldung:
12.04.89 Patentblatt 89/15

(84) Benannte Vertragsstaaten:
**DE ES FR GB IT NL**

(71) Anmelder: **ANDRAE LEONBERG GMBH**
**Neue Ramtelstrasse 48**
**D-7520 Leonberg(DE)**

Anmelder: **A. STEUDLER GMBH + CO. KG**
**Durlacher Strasse 35**
**D-7530 Pforzheim(DE)**

(72) Erfinder: **Förster, Michael, Dipl.-Ing.**
**Nauener Strasse 19a**
**D-7000 Stuttgart 70(DE)**
Erfinder: **Hentzschel, Hans-Peter, Dr. rer. nat.**
**Osserstrasse 34**
**D-8000 München 80(DE)**
Erfinder: **Leiter, Alfred**
**Gesellstrasse 67a**
**D-7530 Pforzheim(DE)**
Erfinder: **Weber, Gerhard**
**Steigäckerstrasse 36**
**D-7142 Marbach/Neckar(DE)**

(74) Vertreter: **Zinnecker, Armin, Dipl.-Ing. et al**
**Rechtsanwälte Eduard Lorenz - Dipl.-Ing.**
**Hans-K. Gossel Dr. Ina Philipps - Dr. Paul B.**
**Schäuble Dr. Siegfried Jackermeier Dipl.-Ing.**
**Armin Zinnecker**
**Widenmayerstrasse 23 D-8000 München**
**22(DE)**

(54) **Induktiver Näherungssensor.**

(57) Der Sensor besitzt einen durch Annähern eines elektrisch leitenden Gegenstandes (Dämpfungsglied) bedämpfbaren LC-Schwingkreis und eine Auswerteschaltung zur Ermittlung der Schwingungsdämpfung. Damit die Schwingungsdämpfung auf besonders einfache und zuverlässige Weise bestimmt werden kann, ist die Auswerteschaltung eine Zählschaltung, die die Anzahl der Schwingungen zählt, deren Amplitude einen vorwählbaren Wert (4, 5) überschreitet.

LC-Oszillator
Schwach gedämpft

FIG.1

□ Oszillatoramplitude          —— Verstärkerausgang

—— Schmitt-Trigger

## Induktiver Näherungssensor

Die Erfindung betrifft einen induktiven Näherungssensor mit einem durch Annähern eines elektrisch leitenden Gegenstandes (Dämpfungslied) bedämpfbaren LC-Schwingkreis und mit einer Auswerteschaltung zur Ermittlung der Schwingungsdämpfung. Weiterhin betrifft die Erfindung einen Ereigniszähler, insbesondere einen Umdrehungszähler, einen Durchflußmengenzähler und einen Wasserzähler, der unter Verwendung eines derartigen induktiven Näherungssensors arbeitet.

Ein derartiger induktiver Näherungssensor ist aus der DE-OS 33 18 900 bekannt. Dieser Näherungssensor beruht auf folgendem Prinzip: Nach der Anregung des LC-Schwingkreises schwingt dieser mit einer bestimmten, durch die Induktivität und Kapazität vorgegebenen Frequenz. Wenn sich das Dämpfungsglied außerhalb des Einwirkungsbereichs des induktiven Näherungssensors befindet, klingt diese Schwingung relativ langsam ab. Der Grad der Dämpfung der vom Dämpfungsglied unbeeinflußten Schwingung hängt dabei von der Güte des Schwingkreises ab. Wenn das Dämpfungsglied in den Einwirkungsbereich des induktiven Näherungssensors gelangt, wird die in dem LC-Schwingkreis erzeugte Schwingung stärker gedämpft. Der Dämpfungsgrad hängt dabei von dem Dämpfungsglied und von anderen Parametern, insbesondere von der Entfernung des Dämpfungsgliedes von dem induktiven Näherungssensor ab. Der induktive Näherungssensor ist also zur Entfernungsmessung geeignet, da die im LC-Schwingkreis des Näherungssensors erzeugte Dämpfung ein Maß für die Entfernung des Dämpfungsgliedes liefert.

Zur Bestimmung des Dämpfungsgrades wird bei dem aus der DE-OS 33 18 900 vorbekannten induktiven Näherungssensor der Mittelwert der gleichgerichteten Schwingung gebildet. Je kleiner dieser Mittelwert ist, desto größer ist die Dämpfung. Eine weitere Möglichkeit zur Bestimmung der Dämpfung besteht darin, zu einem bestimmten Zeitpunkt nach der Anregung des LC-Schwingkreises die Höhe der Amplitude der abklingenden Schwingung zu bestimmen.

Aufgabe der Erfindung ist es, einen induktiven Näherungssensor der eingangs angegeben Art zu schaffen, der eine besonders einfache und zuverlässige Bestimmung der Schwingungsdämpfung ermöglicht.

Erfindungsgemäß wird diese Aufgabe dadurch gelöst, daß die Auswerteschaltung eine Zählschaltung beinhaltet, die die Anzahl der Schwingungen zählt, deren Amplitude einen vorwählbaren Wert überschreitet. Diese Art der Auswertung ist deshalb besonders einfach, weil auf analoge Bauteile verzichtet werden kann, die Auswertung also ausschließlich auf digitale Weise erfolgt. Der ermittelte Dämpfungsgrad kann auch auf digitale Weise weiterverarbeitet werden, ohne daß er vorher durch einen Analog-Digital-Wandler erst in einen digitalen Wert umgewandelt werden müßte. Der erfindungsgemäße Näherungssensor arbeitet also besonders zuverlässig.

In einer vorteilhaften Weiterbildung der Erfindung beinhaltet die Auswerteschaltung einen Verstärker, der das abklingende Signal des LC-Schwingkreises auf konstante (digitale) Pegel verstärkt, wenn die Schwingungsamplitude einen vorgegebenen Schwellenwert überschreitet, und der bei Unterschreitung des vorgegebenen Schwellwertes den erreichten Pegel beibehält. Es wird also ein Verstärker verwendet, der die Schwingungsamplitude in ein digitales Rechtecksignal umwandelt, solange diese Schwingungsamplitude den vorgegebenen Schwellwert überschreitet. Bei Unterschreitung dieses vorgegebenen Schwellwertes wird der erreichte Pegel beibehalten; es wird also einer der beiden digitalen Werte statisch eingenommen. Hierdurch ergibt sich der Vorteil, daß bereits von der Auswerteschaltung ein digitalisiertes Signal erzeugt wird, welches ein Maß für die Dämpfung liefert und welches auf bekannte Weise einfach digital weiterverarbeitet werden kann. Für die weitere Auswertung des von der Auswerteschaltung gelieferten digitalen Signales sind also Standardbauteile verwendbar.

Nach einer weiteren vorteilhaften Weiterbildung der Erfindung be inhaltet die Auswerteschaltung einen übersteuerten Verstärker, der die Schwingungen zunächst verstärkt. Weiterhin beinhaltet die Auswerteschaltung einen Schmitt-Trigger, der die verstärkten Schwingungen in Rechteckimpulse konstanter Amplitude (digitale Ausgangswerte) wandelt, solange die ansteigende Flanke der verstärkten Schwingungen eine obere Grenze überschreitet oder die abfallende Flanke der verstärkten Schwingungen eine untere Grenze unterschreitet.

Eine weitere vorteilhafte Weiterbildung der Erfindung ist gekennzeichnet durch einen Pulsgeber zur periodischen Erregung des LC-Schwingkreises. Der zeitliche Abstand der periodischen Erregungen muß dabei größer sein als die Abklingdauer der Schwingung des LC-Schwingkreises im vom Dämpfungsglied unbeeinflußten Zustand. Die periodische Erregung kann mit konstanter Frequenz erfolgen. Dies ist jedoch nicht zwingend. Es ist auch möglich, den LC-Schwingkreis nach einem vorgebenen Programm periodisch zu erregen. Weiterhin kann der LC-Schwingkreis in Abhängigkeit gewisser Zustände oder Ereignisse im gesamten Auswertesystem erregt werden.

Wenn der Verstärker einschaltbar und abschaltbar ist, ergibt sich die Möglichkeit einer weiteren Energieeinsparung. Dies gilt insbesondere dann, wenn der Verstärker im abgeschalteten Zustand sehr wenig oder nahezu keinen Strom verbraucht. Dies ist beispielsweise bei Verstärkern der Fall, die in CMOS-Technik realisiert sind.

Besonders vorteilhaft wird der Verstärker eingeschaltet, wenn an der Zählschaltung Zählimpulse anliegen, und/oder wird der Verstärker ausgeschaltet, wenn an der Zählschaltung keine Zählimpulse anliegen. Der Stromverbrauch des Verstärkers wird also auf das Mindestmaß, das zum Zählen erforderlich ist, herabgesetzt.

In vorteilhafter Weiterbildung der Erfindung unterteilt die Auswerteschaltung den Bereich der zählbaren Schwingungen durch eine oder mehrere Schwellen in Unterbereiche. Mit der Anzahl der Schwellen wächst einerseits die Auflösung, also die Genauigkeit der Auswertung, andererseits der Aufwand, der zur Realisierung der Schaltung erforderlich ist. Für gewisse Anwendungsfälle genügt eine relativ grobe Auflösung, die mit wenig schaltungstechnischem Aufwand verwirklicht werden kann. In gewissen anderen Anwendungsfällen müssen mehrere Schwellen vorgesehen werden, die zwar nur relativ aufwendig realisierbar sind, die jedoch eine höhere Auflösung gestatten.

Die Auswerteschaltung kann ein oder mehrere digitale Signale erzeugen, abhängig davon, in welchem der Unterbereiche die gezählte Schwingungszahl liegt.

In vorteilhafter Weiterbildung der Erfindung besitzt die Auswerteschaltung zwei Schwellen, mit denen der Bereich der zählbaren Schwingungen in zwei äußere Unterbereiche und einen Zwischenbereich unterteilt wird. Weiterhin schaltet ein digitales Signal nur dann um, wenn von einem der äußeren Unterbereiche kommend der andere äußere Unterbereich erreicht wird.

Durch diese derart erzeugte Hysterese werden kleine Unregelmäßigkeiten im Verlauf der Anzahl der gezählten Schwingungen über der Zeit ausgeglichen. Derartige Schwankungen treten in der Praxis häufig auf, so daß sie herausgefiltert werden müssen, was mit der soeben beschriebenen Verfahrensweise geschehen kann.

Die Auswerteschaltung kann eine oder mehrere Schwellen besitzen, mit denen der Bereich der zählbaren Schwingungen in zulässige oder unzulässige Unterbereiche unterteilt wird und entsprechende digitale Signale erzeugt werden. Dies ermöglicht eine Fehlererkennung: Unzulässige Zählergebnisse können auf diese Weise eliminiert werden.

In vorteilhafter Weiterbildung der Erfindung verarbeitet die Auswerteschaltung die von ihr erzeugten digitalen Signale nur dann weiter, wenn die entsprechenden Bedingungen in ununterbrochener Reihenfolge mehrmals auftreten. Dies dient der Störsicherheit: Ein Auswerteergebnis wird nur dann als gültig angesehen, wenn es mehrmals in ununterbrochener Reihenfolge aufgetreten ist. Je größer die Anzahl der Wiederholungen ist, die für ein gültiges Zählergebnis vorausgesetzt werden, desto größer ist einerseits die Sicherheit vor Fehlern, desto geringer ist aber andererseits die Abtastfrequenz.

Ein Ausführungsbeispiel der Erfindung wird nachstehend anhand der beigefügten Zeichnungen im einzelnen erläutert. In den Zeichnungen zeigt

Fig. 1 einen Schwingungsverlauf bei schwach gedämpftem LC-Oszillator,

Fig. 2 einen Schwingungsverlauf bei stark gedämpftem LC-Oszillator,

Fig. 3 einen schaltbaren Verstärker,

Fig. 4 einen Schwingungsverlauf eines periodisch erregten Schwingkreises,

Fig. 5 einen Verlauf gezählter Schwingungen über der Zeit,

Fig. 6 das aus der Kurve gemäß Fig. 5 abgeleitete digitale Signal und

Fig. 7 eine schematische Darstellung zulässiger und unzulässiger Bereiche von Schwingungszählergebnissen,

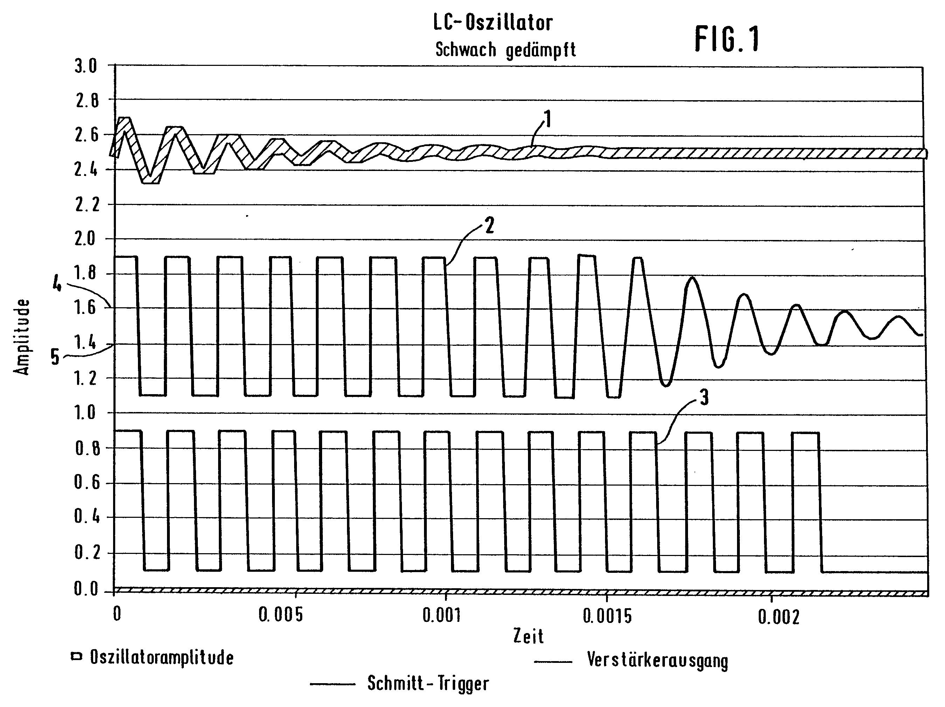

In der Fig. 1 zeigt die Kurve 1 den Verlauf eines Signals des LC-Schwingkreises. Es liegt also eine gedämpfte Schwingung vor. Die Kurve 2 entsteht aus der Kurve 1 dadurch, daß das Signal der Kurve 1 von einem übersteuerten Verstärker verstärkt wird. Hierdurch wird also zunächst ein im wesentlichen rechteckiges Signal erzeugt, solange die Amplitude der Kurve 1 sehr groß ist. Mit dem Absinken der Amplitude der Kurve 1 werden die Flanken der Rechtecke zunehmend flacher, bis sich ein sinusförmiger Verlauf ergibt.

Die Kurve 3 entsteht aus der Kurve 2 dadurch, daß das Signal des Kurvenverlaufs 2 von einem Schmitt-Trigger verarbeitet wird. Sobald die ansteigende Flanke des Signals 2 den oberen Grenzwert 4 überschreitet, geht das Signal 3 auf seinen oberen digitalen Pegel. Sobald die abfallende Flanke des Signals 2 den unteren Grenzwert 5 unterschreitet, geht das Signal 3 auf seinen unteren digitalen Pegel. Das Signal 3 behält am Ende seinen unteren digitalen Wert bei, da die Kurve 2 nach dem letzten Unterschreiten der unteren Grenze 5 die obere Grenze 4 nicht mehr über schreitet.

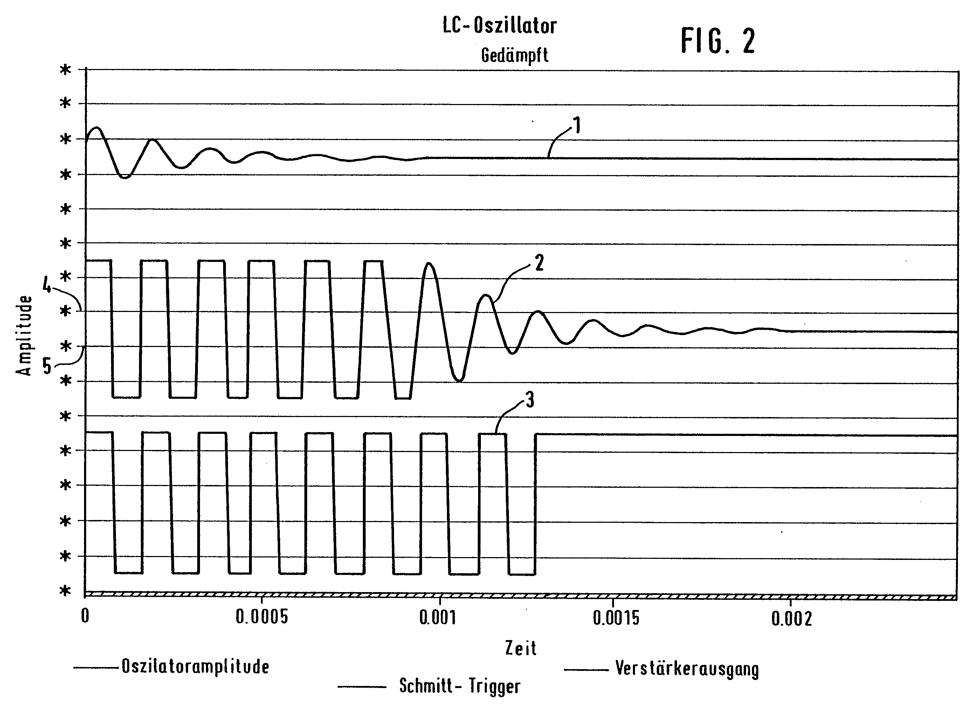

Die Fig. 2 zeigt in einer der Fig. 1 analogen Darstellung die Verhältnisse bei einer stark gedämpften Schwingung des LC-Schwingkreises. Gleiche Kurvenverläufe bzw. Schwellwerte sind dabei mit gleichen Bezugsziffern versehen, so daß auf die Erläuterungen zur Fig. 1 verwiesen werden kann.

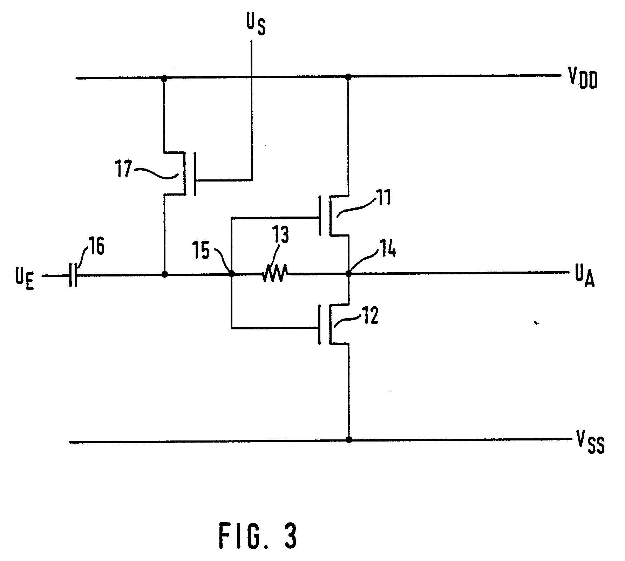

Die Fig. 3 zeigt einen Verstärker, der das Signal der Kurve 1 in den Figuren 1 und 2 in dasjenige der Kurve 2 überführt. Durch diesen Verstärker kann also die Spannung über dem Kondensator eines Parallelschwingkreises verstärkt werden. Die Verstärkerschaltung gemäß Fig. 3 kann in CMOS-Technik realisiert werden, um einen möglichst geringen Stromverbrauch zu erreichen. Die eigentliche Verstärkerschaltung besteht aus zwei Transistoren 11 und 12 und einem Widerstand 13. Die beiden Transistoren 11 und 12 sind in Serie geschaltet. Zwischen ihnen wird die Ausgangsspannung UA bei 14 abgegriffen. Weiterhin sind die beiden Transistoren 11 und 12 bei 15 miteinander verbunden. Der Widerstand 13 befindet sich zwischen den soeben beschriebenen Verbindungsstellen 14 und 15. Einer der beiden Transistoren 11 und 12 muß -zwingend durch die CMOS-Technik vorgegeben - ein n-Kanal-Transistor sein, der andere ein p-Kanal-Transistor. Der Verstärker ist vorzugsweise mit dem Eingang (Eingangsspannung UE) durch einen Kondensator 16 kapazitiv gekoppelt. Der Verstärker, bestehend aus den Transistoren 11 und 12 und den Widerstand 13, kann durch einen Schalter 17 aktiviert und deaktiviert werden. Dieser Schalter 17 ist bei der Schaltung gemäß Fig. 3 wiederum durch einen Transistor realisiert. Dieser Transistor 17 wird von einer Steuerspannung US getaktet, und zwar synchron mit der Anregung des LC-Schwingkreises. Der Steuertransistor 17 liegt zwischen der Betriebsspannung VDD und der Eingangsspannung. Er könnte auch zwischen der Eingangsspannung und VSS (Masse) liegen.

Wenn der Steuertransistor 17 durchgeschaltet ist, dann ist einer der beiden Transistoren 11 bzw. 12 des Verstärkers zwangsläufig gesperrt, da diese beiden Transistoren bei 15 miteinander verbunden sind. Es fließt dann also kein Strom durch den Verstärker. Der im Verstärker vorhandene Widerstand 13 verbraucht in diesem Fall zwangsläufig zwar noch Strom; durch eine geeignete Dimensionierung dieses Widerstandes 13 kann dieser Stromverbrauch jedoch gering gehalten werden.

Beim Einschalten des Verstärkers wird der Maximalwert der Verstärkung von Null ausgehend allmählich erreicht. In erster Näherung hängt die Zeitkonstante dieses Vorgangs von der kapazitiven Kopplung, also der Kapazität des Koppelkondensators 16, und von dem Widerstand 13 ab. Bei diesem Widerstand 13 handelt es sich um einen Rückkoppelwiderstand, der zwischen dem Eingang und dem Ausgang des Verstärkers liegt.

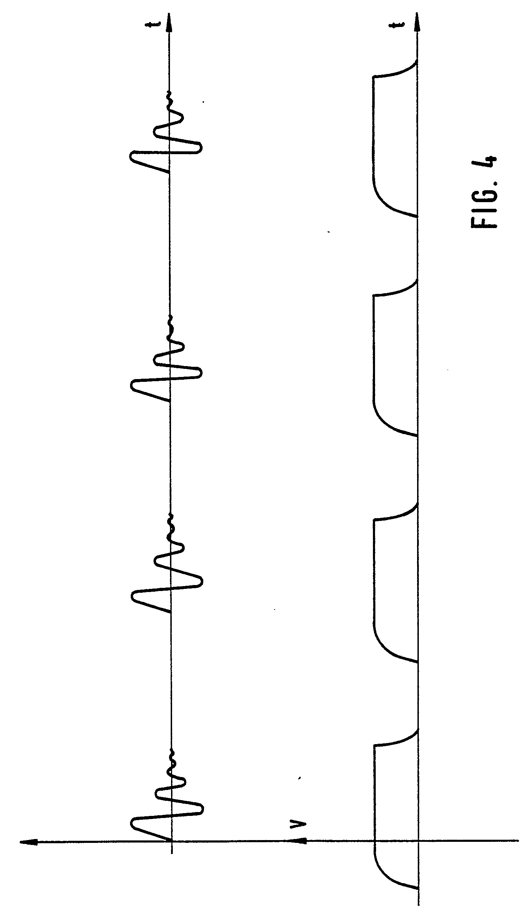

Fig. 4 zeigt oben mehrere abklingende Schwingungen des LC-Schwingkreises und unten die Verstärkung des in Fig. 3 gezeigten Verstärkers. Der Schalttransistor 17 der Schaltung gemäß Fig. 3 wird derart getaktet, daß zum Zeitpunkt des Beginns der Schwingung des Schwingkreises bereits annähernd vollständige Verstärkung V des Verstärkers vorhanden ist. Der Verstärker kann entweder dann abgeschaltet werden, wenn eine ausreichende Anzahl von Zählimpulsen erkannt worden ist. Er kann aber auch nach einer im voraus festgelegten, für jeden Anwendungsfall ausreichenden Zeitdauer abgeschaltet werden. Die Zeitkonstante des Abschaltens des Verstärkers hängt in erster Linie von der Kapazität des Koppelkondensators 16 und vom Widerstand des Schalttransistors 17 ab. Der vorteil der gesamten in Fig. 3 gezeigten Anordnung liegt darin, daß der Verstärker nur dann eingeschaltet ist und also auch nur dann Strom verbraucht, wenn Impulse gezählt werden müssen. In den Pausen zwischen den verschiedenen Anregungen des Schwingkreises (vgl. Fig. 4) ist auch der Verstärker deaktiviert und braucht keinen Strom.

Falls in den Pausen zwischen zwei Anregungen (vgl. Fig. 4 oben) Störimpulse auftreten sollten, werden diese nicht verstärkt. Sie werden also vollkommen unterdrückt und können ein Zählergebnis nicht verfälschen.

Ein weiterer Vorteil der in Fig. 3 gezeigten Schaltung liegt darin, daß sie vollständig in CMOS-Technik realisiert werden kann. Wenn also auch die übrige Schaltung (Auswerteschaltung, Zählschaltung etc.) in dieser Technik realisiert wird, kann die gesamte Schaltung auf einfache Weise verwirklicht werden.

Ein weiterer Vorteil der Schaltung gemäß Fig. 3 liegt darin, daß auf einen Operationsverstärker verzichtet werden kann. Ein derartiger Operationsverstärker verbraucht im allgemeinen mehr Strom.

Der obere Teil der Fig. 4 zeigt vier Anregungen, also vier hintereinanderliegende, durch den Pulsgeber periodisch erregte Schwingungen des Schwingkreises. Jeder dieser vier Schwingungsverläufe liefert ein Zählergebnis. Diese Zählergebnisse pro Schwingungsanregung können über der Zeit dargestellt werden.

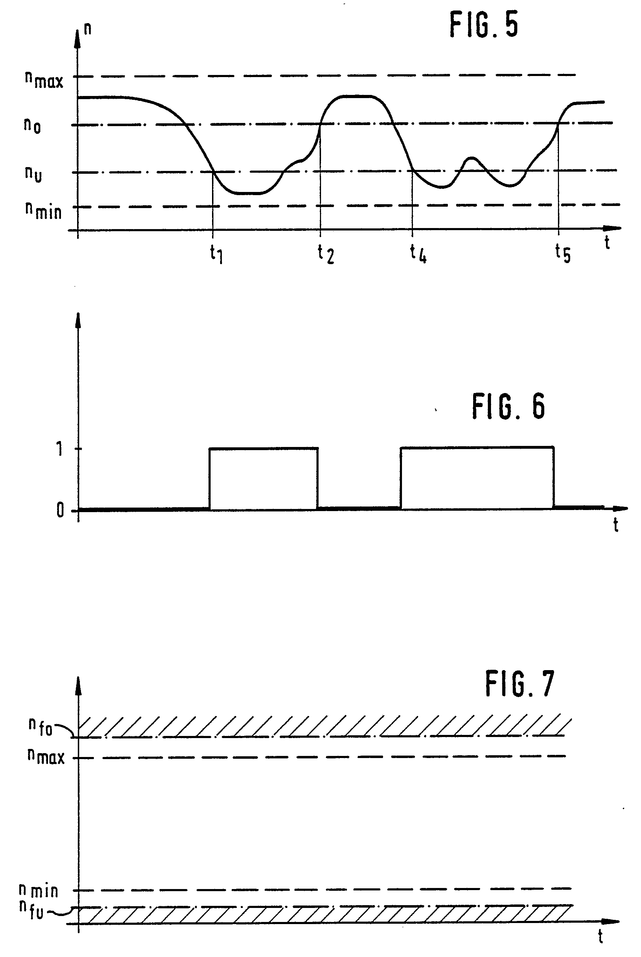

Die Fig. 5 zeigt einen derartigen Verlauf der Anzahl n der gezählten Schwingungen über der Zeit t. Die Schwingungsanzahl nmax entspricht derjenigen bei vom Dämpfungsglied unbeeinflußtem Schwingkreis. Die Anzahl nmin entspricht derjenigen bei durch das Dämpfungsglied größtmöglich beeinflußtem Schwingkreis. Die Zählwerte n bewegen sich also zwischen diesen beiden Grenzen nmin und nmax. Mit strichpunktierten Linien sind zwei Schwellen nu und no eingezeichnet, also eine untere Schwelle und eine obere Schwelle, die den zulässigen Bereich zwischen nmin und nmax in drei Unterbereiche unterteilen, nämlich in zwei äußere Unterbereiche zwischen nmin und nu und zwischen no und nmax und in einen Zwischenbereich zwischen nu und no.

Aus dem Zählwerteverlauf der Fig. 5 wird das digitale Signal der Fig. 6 abgeleitet. Dieses digitale Signal befindet sich zunächst auf dem Wert Null. Es wird dann auf den Wert 1 umgeschaltet, wenn der Zählwert n zur Zeit t1, vom oberen Bereich kommend, in den unteren Bereich gelangt. Das digitale Signal wird dann auf den Wert Null zurück umgeschaltet, wenn zum Zeitpunkt t2 der Zählwert n vom unteren Unterbereich kommend, den oberen Unterbereich erreicht. Durch die beiden Schwellen nu und no wird also eine Hysterese erzeugt.

Der Sinn dieser Hysterese wird anhand des rechten Teils der Kurve in Fig. 5 zwischen den Zeitpunkten t4 und t5 deutlich. Nachdem zum Zeitpunkt t4 der untere Bereich zwischen nmin und nu erreicht worden ist, wird das digitale Signal der Fig. 6 auf den Wert 1 umgeschaltet. Kurz darauf erreicht die Zählwertkurve n den Zwischenbereich zwischen nu und no. Eine Umschaltung des digitalen Signals erfolgt dadurch jedoch noch nicht. Eine Umschaltung erfolgt auch dann nicht, wenn der Zählwertverlauf n vom Zwischenbereich zwischen nu und no wieder in den unteren Unterbereich gelangt. Die Umschaltung des digitalen Signals auf den Wert Null erfolgt vielmehr erst dann, wenn - ausgehend vom unteren Unterbereich zwischen nmin und nu - der obere Unterbereich zwischen no und nmax erreicht wird, also im Zeitpunkt t5. Durch diese künstlich erzeugte Hysterese werden also kleine Schwankungen im Zählwertverlauf ausgeglichen.

Der zulässige Bereich zwischen nmin und nmax kann natürlich auch in mehrere Unterbereiche unterteilt werden. Anstelle des zweiwertigen digitalen Signals der Fig. 6 können auch mehrwertige digitale Signale aus dem Zählkurvenverlauf abgeleitet werden.

Die Fig. 7 zeigt eine untere Fehlergrenze nfu unter dem unteren zulässigen Wert nmin. Falls Zählwerte n ermittelt werden, die unterhalb dieses unteren Fehlergrenzwertes liegen, die also kleiner sind als nfu, kann ein Fehlersignal erzeugt werden. Der entsprechende unzulässige Bereich ist in Fig. 7 schraffiert dargestellt. Die untere Fehlergrenze nfu kann auch mit nmin übereinstimmen. Dementsprechend ist oberhalb des maximalen zulässigen Zählwerts nmax eine obere Fehlergrenze nfo strichpunktiert eingezeichnet; der darüberliegende, unzulässige Fehlerbereich ist ebenfalls schraffiert. Wenn ein Zählwert n erkannt wird, der oberhalb der oberen Fehlergrenze nfo liegt, kann ein Fehlersignal erzeugt werden.

## Ansprüche

1. Induktiver Näherungssensor mit einem durch Annähern eines elektrisch leitenden Gegenstandes (Dämpfungsglied) bedämpfbaren LC-Schwingkreis und mit einer Auswerteschaltung zur Ermittlung der Schwingungsdämpfung,

**dadurch gekennzeichnet,**

daß die Auswerteschaltung eine Zählschaltung beinhaltet, die die Anzahl der Schwingungen zählt, deren Amplitude einen vorwählbaren Wert überschreitet.

2. Induktiver Näherungssensor nach Anspruch 1, dadurch gekennzeichnet, daß die Auswerteschaltung einen Verstärker beinhaltet, der das abklingende Signal des LC-Schwingkreises auf konstante (digitale) Pegel verstärkt, wenn die Schwingungsamplitude einen vorgegebenen Schwellwert überschreitet, und der bei Unterschreitung des vorgegebenen Schwellwertes den erreichten Pegel beibehält.

3. Induktiver Näherungssensor nach Anspruch 2, dadurch gekennzeichnet, daß die Auswerteschaltung einen übersteuerten Verstärker beinhaltet, der die Schwingungen zunächst verstärkt, und einen Schmitt-Trigger, der die verstärkten Schwingungen in Rechteckimpulse konstanter Amplitude (digitale Ausgangs werte) wandelt, solange die ansteigende Flanke der verstärkten Schwingungen eine obere Grenze (4) überschreitet oder die abfallende Flanke der verstärkten Schwingungen eine untere Grenze (5) unterschreitet.

4. Induktiver Näherungssensor nach einem der vorhergehenden Ansprüche, gekennzeichnet durch einen Pulsgeber zur periodischen Erregung des LC-Schwingkreises.

5. Induktiver Näherungssensor nach einem der Ansprüche 2 bis 4, dadurch gekennzeichnet, daß der Verstärker einschaltbar und abschaltbar ist.

6. Induktiver Näherungssensor nach Anspruch 5, dadurch gekennzeichnet, daß der Verstärker einschaltbar ist, wenn an der Zählschaltung Zählimpulse anliegen.

7. Induktiver Näherungssensor nach Anspruch 5 oder 6, dadurch gekennzeichnet, daß der Verstärker abschaltbar ist, wenn an der Zählschaltung keine Zählimpulse anliegen.

8. Induktiver Näherungssensor nach einem der Ansprüche 2 bis 7, dadurch gekennzeichnet, daß der Verstärker in CMOS-Technik realisiert ist.

9. Induktiver Näherungssensor nach einem der vorhergehenden Ansprüche, dadurch gekennzeichnet, daß die Auswerteschaltung den Bereich (nmin, nmax) der zählbaren Schwingungen (n) durch eine oder mehrere Schwellen (nu, no) unterteilt.

10. Induktiver Näherungssensor nach einem der vorhergehenden Ansprüche, dadurch gekennzeichnet, daß die Auswerteschaltung ein oder mehrere digitale Signale (Fig. 6) erzeugt, abhängig davon, in welchem der Unterbereiche (nmin-nu, nu-no, no-nmax) die gezählte Schwingungszahl (n) liegt.

11. Induktiver Näherungssensor nach einem der vorhergehenden Ansprüche, dadurch gekennzeichnet, daß die Auswerteschaltung zwei Schwellen (nu, no) besitzt, mit denen der Bereich (nmin, nmax) der zählbaren Schwingungen (n) in zwei äußere Unterbereiche (nmin-nu, no-nmax) und einen Zwischenbereich (nu-no) unterteilt wird, und ein digitales Signal nur dann umschaltet, wenn von einem der äußeren Unterbereiche kommend der andere äußere Bereich erreicht wird.

12. Induktiver Näherungssensor nach einem der vorhergehenden Ansprüche, dadurch gekennzeichnet, daß die Auswerteschaltung eine oder mehrere Schwellen (nfu, nfo) besitzt, mit denen der Bereich der zählbaren Schwingungen in zulässige oder unzulässige Unterbereiche unterteilt wird, und entsprechende digitale Signale erzeugt werden.

13. Induktiver Näherungssensor nach einem der vorhergehenden Ansprüche, dadurch gekennzeichnet, daß die Auswerteschaltung die von ihr erzeugten digitalen Signale nur dann weiterverarbeitet, wenn die entsprechenden Bedingungen in ununterbrochener Reihenfolge mehrmals auftreten.

14. Ereigniszähler, gekennzeichnet durch einen induktiven Näherungssensor nach einem der Ansprüche 1 bis 13.

15. Ereigniszähler nach Anspruch 14, dadurch gekennzeichnet, daß er ein Umdrehungszähler ist.

16. Ereigniszähler nach Anspruch 15, dadurch gekennzeichnet, daß eine Umdrehung einer bestimmten Menge einer zählbaren physikalischen Größe (Länge, Energie etc.) entspricht.

17. Umdrehungszähler nach Anspruch 16, dadurch gekennzeichnet, daß er ein Durchflußmengenzähler, insbesondere Wasserzähler, ist.

LC-Oszillator
Schwach gedämpft

FIG.1

EP 0 311 129 A1

Amplitude (y-axis): 3.0, 2.8, 2.6, 2.4, 2.2, 2.0, 1.8, 1.6, 1.4, 1.2, 1.0, 0.8, 0.6, 0.4, 0.2, 0.0

Zeit (x-axis): 0, 0.005, 0.001, 0.0015, 0.002

▭ Oszillatoramplitude        —— Verstärkerausgang

—— Schmitt-Trigger

LC-Oszillator

Gedämpft

FIG. 2

EP 0 311 129 A1

FIG. 3

FIG. 4

FIG. 5

FIG. 6

FIG. 7

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| X | EP-A-0 228 019 (LINK) * Spalte 4, Zeile 26 - Spalte 7, Zeile 4; Figuren 1,2 * | 1,2,4,9 ,10 | H 03 K 17/95 G 01 F 1/075 |
| Y | | 14-17 | |
| | --- | | |
| Y | EP-A-0 021 978 (THOMSON-CSF) * Zusammenfassung * ----- | 14-17 | |

| | |
|---|---|
| | **RECHERCHIERTE SACHGEBIETE (Int. Cl.4)** |
| | H 03 K<br>H 03 B<br>G 01 F<br>G 01 V |

Der vorliegende Recherchenbericht wurde für alle Patentansprüche erstellt

| Recherchenort | Abschlußdatum der Recherche | Prüfer |
|---|---|---|
| DEN HAAG | 20-12-1988 | CANTARELLI R.J.H. |

KATEGORIE DER GENANNTEN DOKUMENTE

X : von besonderer Bedeutung allein betrachtet
Y : von besonderer Bedeutung in Verbindung mit einer
anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder
nach dem Anmeldedatum veröffentlicht worden ist
D : in der Anmeldung angeführtes Dokument
L : aus andern Gründen angeführtes Dokument
.......................................................................
& : Mitglied der gleichen Patentfamilie, übereinstimmendes
Dokument

EPO FORM 1503 03.82 (P0403)